(19) **Europäisches Patentamt / European Patent Office / Office européen des brevets**

(11) **EP 2 031 023 A1**

(12) **EUROPEAN PATENT APPLICATION**
published in accordance with Art. 153(4) EPC

(43) Date of publication:
**04.03.2009 Bulletin 2009/10**

(21) Application number: **07737316.5**

(22) Date of filing: **22.02.2007**

(51) Int Cl.:
*C08L 101/00* (2006.01)   *C08L 63/00* (2006.01)
*C08L 75/04* (2006.01)   *C09D 11/00* (2006.01)
*C09D 163/00* (2006.01)   *C09D 175/04* (2006.01)
*C09D 201/00* (2006.01)   *H05K 3/28* (2006.01)

(86) International application number:
**PCT/JP2007/053323**

(87) International publication number:
**WO 2007/097405 (30.08.2007 Gazette 2007/35)**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(30) Priority: **27.02.2006 JP 2006050026**

(71) Applicant: **Showa Denko K.K.**
**Tokyo 105-8518 (JP)**

(72) Inventors:
 • **KIMURA, Kazuya**
   **Kawasaki-shi, Kanagawa 2100867 (JP)**
 • **OGATA, Yuichiro**
   **Kawasaki-shi, Kanagawa 2100867 (JP)**

(74) Representative: **Strehl Schübel-Hopf & Partner**
**Maximilianstrasse 54**
**80538 München (DE)**

(54) **THERMOSETTING RESIN COMPOSITION CONTAINING LOW-CHLORINE MULTIFUNCTIONAL ALIPHATIC GLYCIDYL ETHER COMPOUND, CURED PRODUCT OF SUCH COMPOSITION AND USE THEREOF**

(57)    An object of the invention is to provide a thermosetting resin composition having excellent low temperature curing properties, tack properties, flexibility and electric properties, cured products made from the composition and uses thereof. The thermosetting resin composition of the invention comprises (A) a thermosetting resin, preferably a carboxyl group containing resin, and (B) a polyfunctional aliphatic glycidyl ether compound having a total chlorine amount of less than 0.7 % by mass. The cured products of the thermosetting resin composition is used as insulating protective coating films for printed wiring boards, flexible printed wiring boards, chip on films and the like.

EP 2 031 023 A1

**Description**

TECHNICAL FIELD

The present invention relates to a thermosetting resin composition containing a thermosetting resin and a polyfunctional aliphatic glycidyl ether compound having a total chlorine amount of less than 0.7 % by mass, cured products of the composition and uses thereof. More specifically, it relates to a thermosetting resin composition, which has excellent low temperature curing properties, tack properties, flexibility and electric insulating properties, and is suitably used for protective films or electric insulating materials such as solder resists and interlayer insulating films, IC or ultra LSI sealing materials, laminated plates and the like, and cured products of the composition and uses thereof.

TECHNICAL BACKGROUND

It is known that it is effective to use a polyfunctional compound for conventional curing compositions as a means of improving the curing properties as shown in "Principles of Polymer Chemistry" (non-Patent Document 1). However, the use of aromatic glycidyl ether, alicyclic glycidyl ether or cresol novolak glycidyl ether as a component of a thermosetting resin composition has problems such that the low warping properties and the flexibility of a cured product are remarkably reduced.

As a means for improving a balance among low temperature curing properties, heat resistance and flexibility, it is known to use a polyfunctional aliphatic glycidyl ether compound as disclosed in JP-A-2003-292578 (Patent Document 1) or JP-A-H11(1999)-246759 (Patent Document 2). However, conventional polyfunctional aliphatic glycidyl ether compounds contain about 5 to 20 % by mass of chlorine and thereby have problems that defect in curing is caused or corrosion of copper wirings is caused by the influence of chlorine impurities to lower the electric insulating properties.

As a means for improving off the lower of the electric insulating properties caused by the corrosion of copper wirings with the influence of chlorine impurities, it is known that the use of an aliphatic glycidyl ether compound in which the total chlorine amount is decreased is effective, as disclosed in JP-A-2001-342240 (Patent Document 3), JP-A-2003-73453 (Patent Document 4) and JP-A-2005-320477 (Patent Document 5). However, the patent documents do not disclose the balance between low temperature curing properties and flexibility.

Non-Patent Document 1: written by P.J.Flory "Principles of Polymer Chemistry" (Cornell Univ. Press, 1953)
Patent Document 1: JP-A-2003-292578
Patent Document 2: JP-A-H11(1999)-246759
Patent Document 3: JP-A-2001-342240
Patent Document 4: JP-A-2003-73453
Patent Document 5: JP-A-2005-320477

DISCLOSURE OF THE INVENTION

OBJECT OF THE INVENTION

The present invention is intended to solve the problems associated with the prior arts, and it is an object of the invention to provide a thermosetting resin composition having excellent low temperature curing properties, tack properties, flexibility and electric properties. It is another object of the invention to provide cured products made from the composition and uses thereof.

MEANS FOR SOLVING THE PROBLEMS

The present inventors have been earnestly studied for solving the above problems. As a result, noting the fact that a system blended with a polyfunctional aliphatic glycidyl ether compound having a total chlorine amount of less than 0.7 % by mass has low temperature curing properties and does not decrease the electric properties, they found that the above problems can be solved by a thermosetting resin composition which comprises a thermosetting resin and a polyfunctional aliphatic glycidyl ether compound having a total chlorine amount of less than 0.7 % by mass. Thus, the present invention has been accomplished. Namely, the present invention relates to the following subjects.

[1] A thermosetting resin composition comprising:

(A) a thermosetting resin and
(B) a polyfunctional aliphatic glycidyl ether compound having a total chlorine amount of less than 0.7 % by mass.

[2] The thermosetting resin composition according to the subject [1]wherein the polyfunctional aliphatic glycidyl ether compound has a number average molecular weight of not more than 1000.

[3] The thermosetting resin composition according to the subject [1]wherein the thermosetting resin (A) is a carboxyl group containing resin.

[4] The thermosetting resin composition according to the subject [3]wherein the carboxyl group containing resin is a carboxyl group containing polyurethane.

[5] The thermosetting resin composition according to the subject [4]wherein the carboxyl group containing polyurethane is obtainable by allowing (a) a polyisocyanate compound to react with (b) a polyol compound and (c) a carboxyl group containing dihydroxy compound provided that the compound (c) is excluded in the compound (b).

[6] The thermosetting resin composition according to the subject [5]wherein the carboxyl group-containing polyurethane is obtainable by allowing (d) a mono-hydroxy compound and/or (e) a mono-isocyanate compound to react with the compounds (a), (b) and (c).

[7] A solder resist ink comprising the thermosetting resin composition as described in any one of the subjects [1] to [6].

[8] A cured product obtainable by curing the thermosetting resin composition as described in any one of the subjects [1] to [6].

[9] An insulating protective film obtainable from the cured product as described in the subject [8].

[10] A printed wiring board, which is covered partly or all over with the cured product as described in the subject [8].

[11] A flexible printed wiring board,which is covered partly or all over with the cured product as described in the subject [8].

[12] A chip on film (COF), which is covered partly or all over with the cured product as described in the subject [8].

[13] An electronic part comprising the cured product as described in the subject [8].

EFFECT OF THE INVENTION

Conventional low temperature curing resin compositions have some defects such as insufficiency in flexibility of a resulting cured product or deterioration in electric insulating properties caused by chlorine impurities. On the other hand, the thermosetting resin composition of the present invention can realize the possession of low temperature curing properties, tack properties, chemical resistance, heat resistance and electric insulating propertiestogether with flexibility which is in a tradeoff relation with these properties, and can form excellent solder resists and protective films with low cost productively.

BEST MODE FOR CARRYING OUT THE INVENTION

The thermosetting resin composition of the present invention will be described in detail below.

The thermosetting resin composition of the invention comprises (A) a thermosetting resin and (B) a polyfunctional aliphatic glycidylether compound having a total chlorine content of less than 0.7 % by mass, and optionally may comprise (C) a curing accelerator. The components for constituting the thermosetting resin composition of the invention are described hereinafter.

(A) Thermosetting resin

Examples of the thermosetting resin (A) used in the invention may include carboxyl group-containing resins, epoxy resins, phenol resins, unsaturated polyester resins, alkyd resins, melamine resins and isocyanate resins. The carboxyl group-containing resins are preferred, and further carboxyl group-containing polyurethane is more preferred from the standpoint of pliability and electric insulating properties of a resulting cured product.

<Carboxyl group containing polyurethane>

A carboxyl group containing polyurethane preferably used in the invention has at least two carboxyl groups in one molecule and has a urethane bond formed by reaction of a polyisocyanate compound with a polyol compound. Such a carboxyl group containing polyurethane can be synthesized by, for example, allowing (a) a polyisocyanate compound to react with (b) a polyol compound and (c) a carboxyl group containing dihydroxy compound. In the reaction, (d) a monohydroxy compound and/or (e) a monoisocyanate compound may be added as a terminal-sealing agent.

Examples of the polyisocyanate compound (a) are diisocyanates such as 2,4-tolylene diisocyanate, 2,6-tolylene diisocyanate, isophorone diisocyanate, 1,6-hexamethylene diisocyanate, 1,3-trimethylene diisocyanate, 1,4-tetramethylene diisocyanate, 2,2,4-trimethyl hexamethylene diisocyanate, 2,4,4-trimethyl hexamethylene diisocyanate, 1,9-nonamethylene diisocyanate, 1,10-decamethylene diisocyanate, 1,4-cyclohexane diisocyanate, 2,2'-diethylether diisocyanate, diphenylmethane-4,4'-diisocyanate, (o, m or p)-xylene diisocyanate, methylene bis(cyclohexyl isocyanate), cyclohexane-1,3-dimethylene diisocyanate, cyclohexane-1,4-dimethylene diisocyanate, 1,5-naphthalene diisocyanate, p-phenylene diisocyanate, 3,3'-methylene ditolylene-4,4'-diisocyanate, 4,4'-diphenylether diisocyanate, tetrachlorophenylene diisocyanate, norbornane diisocyanate and hydrogenated (1,3- or 1,4-)xylylene diisocyanates. These may be used singly or two or more may be combined for use.

Examples of the polyol compound (b) excluding the compound (c) are low molecular weight diols, polycarbonate diols, polyether diols, polybutadienes having a hydroxyl group at both ends and polyester diols. These may be used singly or two or more may be combined for use. Among the compounds, polycarbonate diols are preferably used from the standpoint of flexibility and electric properties such as heat resistance.

Examples of the carboxyl group containing dihydroxy compound (c) are 2,2-dimethylol propionic acid, 2,2-dimethylol butanoic acid, N,N-bishydroxyethyl glycine and N,N-bishydroxyethyl alanine. These may be used singly or two or more may be combined for use. Among the compounds, 2,2-dimethylol propionic acid and 2,2-dimethylol butanoic acid are preferably used from the standpoint of solubility in a solvent.

Examples of the monohydroxy compound (d) are 2-hydroxyethyl (meth)acrylate, hydroxypropyl (meth)acrylate, hydroxybutyl (meth)acrylate, cyclohexane dimethanol mono(meth)acrylate, and caprolactones or oxide alkylene adducts of the above (meth)acrylates, further, glycerin di(meth)acrylate, trimethylol di(meth)acrylate, pentaerythritol tri(meth)acrylate, dipentaerythritol penta(meth)acrylate, ditrimethylol propane tri(meth)acrylate, allyl alcohol, allyloxy ethanol, glycolic acid, hydroxy pivalic acid, methanol, ethanol, n-propanol, isopropanol, n-butanol, iso-butanol, sec-butanol, t-butanol, amyl alcohol, hexyl alcohol and octyl alcohol. These may be used singly or two or more may be combined for use.

Examples of the monoisocyanate compound (e) are (meth)acryloyl oxy ethyl isocyanate, phenyl isocyanate, hexyl isocyanate and dodecyl isocyanate. These may be used singly or two or more may be combined for use.

The carboxyl group containing polyurethane has a number average molecular weight of preferably 500 to 100,000, more preferably 8, 000 to 30, 000. The number average molecular weight is a value determined relative to polystyrene by a gel permeation chromatography (GPC). When the number average molecular weight of the carboxyl group containing polyurethane is lower than the above range, a resulting cured film suffers a loss in elongation, pliability and strength. On the other hand, when it is over the above range, the viscosity becomes too high and thereby the carboxyl group containing polyurethane will be unsuitable for use.

In the present specification, the measuring conditions for GPC are as follows unless otherwise noted.

Name of Apparatus: HPLC unit HSS-2000 manufactured by JASCO Corporation
Column: Shodex column LF-804
Mobile Phase: tetrahydrofuran
Flow rate: 1.0 mL/min
Detector: RI-2031 Plus manufactured by JASCO Corporation
Temperature: 40.0°C
Amount of Specimen: Sample loop 100 µl
Concentration of Specimen: regulated to about 0.1 wt%

The carboxyl group containing polyurethane has an acid value of preferably 5 to 150 mgKOH/g, more preferably 30 to 120 mgKOH/g. When the acid value is lower than the above range, the reactivity with the thermosetting component (B) lowers and thereby the heat resistance will be deteriorated. On the other hand, when it is over the above range, a resulting cured film sometimes lowers in properties as a resist, such as alkali resistance or electric properties. The acid value of the resin is determined in accordance with JISK5407.

In the present specification, the acid value of the resin was determined by the following method.

In a 100 mL Erlenmeyer flask, about 0.2 g of a specimen was weighted using a precision balance. To the flask, 10 mL of an ethanol and toluene mixed solvent having a weight ratio of ethanol to toluene of 1/2 was added and dissolved. Furthermore, 1 to 3 drops of a phenolphthalein ethanol solution was added as an indicator to the flask and stirred sufficiently until the specimen was homogenous. The specimen was titrated with a 0.1 N potassium hydroxide-ethanol solution. When the pink of the indicator continues for 30 sec., neutralization was terminated. From the results, a value was calculated using the following formula and taken as a acid value of the resin.

$$\texttt{Acid value (mgKOH/g) = [B × f × 5.611] / S}$$

B: The amount (mL) of a 0.05N potassium hydroxide-ethanol solution used
f: A factor of a 0.05N potassium hydroxide-ethanol solution
S: A collected amount (g) of a specimen

The carboxyl group containing polyurethane can be synthesized by allowing the polyisocyanate compound (a) to react with the polyol compound (b), the carboxyl group containing dihydroxy compound (c), and optionally the mono-hydroxy compound (d) and monoisocyanate compound (e) in the presence or absence of a known catalyst for urethanization such as dibutyltin dilaurylate using a proper organic solvent. However, it is preferably synthesized in the absence of the catalyst because a final cured film prepared from the polyurethane is improved in physical values at the time of practical use.

As the organic solvent, those having low reactivity with isocyanate can be used and further, organic solvents having no basic functional groups such as amine or the like and a boiling point of at least 110°C, more preferably at least 200°C are preferred. Examples of the solvents are toluene, xylene, ethylbenzene, nitrobenzene, cyclohexane, isophorone, diethylene glycol dimethylether, ethylene glycol diethylether, propyleneglycol methylether acetate, propylene glycol ethylether acetate, diproylene glycol methylether acetate, diethylene glycol ethylether acetate, methyl methoxy propionate, ethyl methoxy propionate, methyl ethoxy propionate, ethyl ethoxy propionate, ethyl acetate, n-butyl acetate, isoamyl acetate, ethyl lactate, acetone, methylethyl ketone, cyclohexanone, N,N-dimethyl formamide, N,N-dimethyl acetoamide, N-methylpyrrolidone, γ-butyrolactone, dimethyl sulfoxide, chloroform, and methylene chloride.

Among them, propylene glycol methylether acetate, propylene glycol ethylether acetate, dipropylene glycol methylether acetate, diethylene glycol ethylether acetate and γ-butyrolactone are particularly preferable in consideration of the facts that organic solvents having low solubility with a resulting carboxyl group containing polyurethane are not preferable and polyurethanes are used as a starting material for inks in the use of electrical materials.

The order of feeding the materials is not particularly limited. Usually, the polyol compound (b) and carboxyl group containing dihydroxy compound (c) are fed firstly and dissolved in the solvent, and then the polyisocyanate compound (a) is added dropwise at a temperature of from 20 to 150°C, preferably 60 to 120°C to the solution and thereafter reacted at a temperature of from 30 to 160°C, preferably 50 to 130°C.

The molar ratio of the materials for feeding is regulated in accordance with the molecular weight or the acid value of an aimed polyurethane. In the case of introducing the monohydroxy compound (d) to a polyurethane, it is necessary to use the polyisocyanate compound (a) in an excess amount as compared with those of the polyol compound (b) and the carboxyl group having dihydroxy compound (c) (the amount of the isocyanate group is excess more than the total amount of the hydroxyl groups) so that the terminals of a polyurethane molecule become isocyanate groups.

Specifically, the molar ratio of these materials for feeding, namely the amount of the polyisocyanate compound (a) : the amounts of the polyol compound (b) + the carboxyl group having dihydroxy compound (c) is 0.5 to 1.5 : 1, preferably 0.8 to 1.2 : 1.

The ratio of the polyol compound (b) to the carboxyl group containing dihydroxy compound (c) is 1:0.1 to 30, preferably 1:0.3 to 10.

When the monohydroxy compound (d) is used, it is preferred that the number of moles of the polyisocyanate compound (a) be in excess of the number of moles of the polyol compound (b) + the carboxyl group containing dihydroxy compound (c), and the monohydroxy compound (d) be used in an amount of from 0.5 to 1.5 times by mole, preferably 0.8 to 1.2 times by mole per the excess number of moles of NCO group.

When the monoisocyanate compound (e) is used, it is preferred that the number of moles of the polyol compound (b) + the carboxyl group having dihydroxy compound (c) be in excess of the number of moles of the polyisocyanate compound (a), and the monoisocyanate compound (e) be used in an amount of from 0.5 to 1.5 times by mole, preferably 0.8 to 1.2 times by mole per the excess number of moles of hydroxyl group.

In order to introduce the monohydroxy compound (d) into the polyurethane, the isocyanate groups remaining at the both terminals of the polyurethane need to be reacted with the monohydroxy compound (d) at the time that the reaction of the polyisocyanate compound (a) with the polyol compound (b) and the carboxyl group containing dihydroxy compound (c) is almost completed, that is, the monohydroxy compound (d) is added dropwise at a temperature of from 20 to 150°C, more preferably 70 to 120°C to the polyurethane solution and then maintained at the same temperature to complete the reaction.

In order to introduce the monoisocyanate compound (e) into the polyurethane, the hydroxyl groups remaining at the both terminals of the polyurethane need to be reacted with the monoisocyanate compound (e) at the time that the reaction of the polyisocyanate compound (a) with the polyol compound (b) and the carboxyl group containing dihydroxy compound (c) is almost completed, that is, the monoisocyanate compound (e) is added dropwise at a temperature of from 20 to 150°C, more preferably 50 to 120°C to the polyurethane solution and then maintained at the same temperature to complete the reaction.

(B) Polyfunctional aliphatic glycidyl ether compound having a total chlorine amount of less than 0.7% by mass

Polyfunctional aliphatic glycidyl ether compounds are thermosetting components curable by the reaction with the thermosetting resin (A). In the present invention, a polyfunctional aliphatic glycidyl ether compound having a total chlorine amount of less than 0.7% by mass (purified product) is used.

Examples of such a polyfunctional aliphatic glycidyl ether compound are polyglycidyl ether compounds such as 1, 6-hexanediol diglycidylether, 1,4-butanediol diglycidylether, cyclohexane dimethanol diglycidylether, trimethylol propane polyglycidylether or diethylene glycohol diglycidylether having a total chlorine amount of less than 0.7 % by mass. The polyfunctional aliphatic glycidyl ether compounds having a total chlorine amount of less than 0.7 % by mass are commercially available. Examples thereof are low chlorine-containing polyfunctional aliphatic glycidyl ethers such as DENACOL EX-212L, EX-216L, EX-214L, EX-321L and EX-850L, manufactured by Nagase Chemtex Co. Furthermore, by decreasing the chlorine amount using a method such as distillation, it is also possible to use polyfunctional aliphatic glycidyl ethers such as DENACOL EX-611, EX-612, EX-614, EX-622, EX-512, EX-521, EX-411, EX-421, EX-313 and EX-314, manufactured by Nagase Chemtex Co. Moreover, it is preferred the polyfunctional aliphatic glycidyl ether compounds be not alicyclic compounds from the viewpoint of easiness in reactivity. The total chlorine amount of the polyfunctional aliphatic glycidyl ether compound is less than 0.7 % by mass, and more preferably less than 0.5 % by mass. When the total chlorine amount is not less than 0.7% by mass, corrosion of copper wirings is accelerated by the influence of chlorine impurities to sometimes make the electric insulating properties worse.

The polyfunctional aliphatic glycidyl ether compound has a number average molecular weight of preferably not more than 1000, more preferably not more than 500. When the number average molecular weight is more than 1000, the mobility of molecules is lowered to sometimes damage the low temperature curing properties. The total chlorine amount can be measured by the Volhard's method, which is one of precipitation titration methods. For example, the amount can be determined by the following manner. Covalent chlorine is decomposed with a metallic sodium to cause chlorine ions and silver nitrate is added to the chlorine ions followed by titration.

In the thermosetting resin compositions of the present invention, the polyfunctional aliphatic glycidyl ether compounds having a total chlorine amount of less than 0.7 % by mass may be used singly or two or more may be combined for use.

The ratio of the epoxy equivalent of the polyfunctional aliphatic glycidyl ether compound to the carboxyl group equivalent of the carboxyl groupcontaining polyurethane is preferably from 1.0 to 3.0. When the epoxy equivalent ratio is lower than the above range, the electric insulating properties of a cured film formed from the thermosetting resin composition are sometimes insufficient. On the other hand, when it is over the above range, the shrinkage amount of a cured film is increased and in the use of the cured film as an insulating protective film for a flexible printed circuit board (FPC), the low anti-warping properties tend to be worse.

In addition to the polyfunctional aliphatic glycidyl ether compounds having a total chlorine amount of less than 0.7 % by mass, the thermosetting resin composition of the present invention may be blended with epoxy compounds having at least two epoxy groups in one molecule as a thermosetting component in order to improve the adhesion with a substrate. Examples thereof are a bisphenol A type epoxy resin, a hydrogenated bisphenol A type epoxy resin, a brominated bisphenol A type epoxy resin, a bisphenol F type epoxy resin, a novolak type epoxy resin, a phenol novolak type epoxy resin, a cresol novolak type epoxy resin, an N-glycidyl type epoxy resin, a bisphenol A novolak type epoxy resin, a chelate type epoxy resin, a glyoxal type epoxy resin, an amino group-containing epoxy resin, a rubber modified epoxy resin, a dicyclopentadiene phenolic type epoxy resin, a silicon modified epoxy resin and an ε-caprolactam modified epoxy resin. Further examples are a bisphenol S type epoxy resin, a diglycidyl phthalate resin, a heterocyclic epoxy resin, a bixylenol type epoxy resin, a biphenol type epoxy resin and a tetraglycidyl xylenoylethane.

(C) Curing accelerator

To the thermosetting resin composition of the present invention, a curing accelerator (C) may be used in accordance with necessity in order to accelerate the curing reaction. The use of the curing accelerator can further improve the properties such as adhesion properties, chemical resistance or heat resistance.

Examples of the curing accelerator (C) are:

imidazole derivatives such as "2MZ", "2E4MZ", "C11Z", "C17Z", "2PZ", "1B2MZ", "2MZ-CN", "2E4MZ-CN", "C11Z-CN", "2PZ-CN", "2PHZ-CN", "2MZ-CNS", "2E4MZ-CNS", "2PZ-CNS", "2MZ-AZINE", "2E4MZ-AZINE", "C11Z-AZINE", "2MA-OK", "2P4MHZ", "2PHZ" and "2P4BHZ" which are manufactured by Shikoku Chemicals Co.;

guanamines such as acetoguanamine and benzoguanamine;

polyamines such as diaminodiphenyl methane, m-phenylene diamine, m-xylene diamine, diaminodiphenyl sulfone, dicyane diamide, urea, urea derivatives, melamine and polybasic hydrazide;

organic acid salts and/or epoxy adducts thereof;

amine complexes of boron trifluoride;

triazine derivatives such as ethyldiamino-S-triazine, 2,4-diamino-S-triazine and 2,4-diamino-6-xylyl-S-triazine;

amines such as trimethyl amine, triethanol amine, N,N-dimethyl octyl amine, N-benzyl dimethyl amine, pyridine, N-methyl morpholine, hexa(N-methyl) melamine, 2,4,6-tris(dimethyl aminophenol), tetramethyl guanidine and m-aminophenol;

polyphenols such as polyvinyl phenol, polyvinyl phenol bromide, phenol novolak and alkylphenol novolak;

organic phosphines such as tributyl phosphine, triphenyl phosphine and tris-2-cyanoethyl phosphine;

phosphonium salts such as tri-n-butyl(2,5-dihydroxyphenyl), phosphonium bromide and hexadecyl tributyl phosphonium chloride;

quaternary ammonium salts such as benzyl trimethyl ammonium chloride and phenyl tributyl ammonium chloride; polybasic acid anhydrides as described above ;

photo cation polymerization catalysts such as diphenyl iodonium tetrafluoroboroate, triphenyl sulfonium hexafluoro antimonate, 2,4,6-triphenylthio pyrilium hexafluorophosphate, "Irgaqure 261" manufactured by Ciba Geigy Ltd., and "Optoma-SP-170" manufactured by Asahi Denka Co.;

styrene-malic anhydride resins; and

known and usual curing agents or curing accelerators such as an equimolar reactant of phenyl isocyanate and dimethyl amine, equimolar reactants of dimethyl amine and organic polyisocyanates such as tolylene diisocyanate or isophorone diisocyanate.

The curing accelerators may be used singly or two or more maybe combined for use. Although the use of the curing accelerator is not essential in the present invention, it can be used in an amount of not more than 25 % by mass based on 100 % by mass of the thermosetting components, in order to especially accelerate curing. The amount is not preferably over 25 % by weight because the amount of components to be sublimated from its cured product is increased, and further the usable time is extremely shortened after mixing the thermosetting resin (A) and the thermosetting components (B).

(D) Organic solvent

In the preparation of the thermosetting resin composition of the present invention, an organic solvent (D) inert to functional groups contained in the composition may be used in order to dissolve or disperse the thermosetting resin (A) and the polyfunctional aliphatic glycidylether compound (B) having a total chlorine amount of less than 0.7 % by mass as the thermosetting components or in order to regulate the viscosity suitable for applications.

Examples of the organic solvent (D) are toluene, xylene, ethylbenzene, nitrobenzene, cyclohexane, isophorone, diethylene glycol dimethylether, ethylene glycol diethylether, carbitol acetate, propylene glycol methylether acetate, propylene glycol ethylether acetate, dipropylene glycol methylether acetate, diethylene glycol butylether acetate, methyl methoxy propionate, ethyl methoxy propionate, methyl ethoxy propionate, ethyl ethoxy propionate, ethyl acetate, n-butyl acetate, isoamyl acetate, ethyl lactate, acetone, methylethyl ketone, cyclohexanone, N,N-dimethyl formamide, N,N-dimethyl acetoamide, N-methyl pyrrolidone, γ-butyrolactone, dimethylsulfoxide, chloroform, methylene chloride and petroleum naphtha. These may be used singly or two or more may be combined for use.

(E) Additives

The thermosetting composition of the present invention may be blended with various additives conventionally known, for example, inorganic fillers such as barium sulfate, talc, calcium carbonate, alumina, powdery glass, powdery quartz or silica; fiber reinforcing materials such as glass fibers, carbon fibers or boron nitride fibers; colorants such as titanium oxide, zinc oxide, carbon black, iron black, organic pigments or organic dyes; antioxidants such as hindered phenol compounds, phosphorus compounds or hindered amine compounds; ultraviolet ray absorbing agents such as benzotriazole compounds or benzophenone compounds.

Furthermore, a viscosity regulator, ion exchanger, flame retardant, antibacterial agent, antifungal agent, anti-aging agent, antistatic agent, plasticizer, lubricant, foaming agent, antifoaming agent or leveling agent may be mixed in accordance with the use.

[Process for producing thermosetting resin composition]

The thermosetting resin composition of the invention can be produced by mixing the above components by a usual process. The mixing process is not particularly limited. Accordingly, some of the components may be mixed and then the others may be mixed, or all the components may be mixed in the batch.

Specifically, the thermosetting resin composition is obtainable by dissolving or dispersing the thermosetting resin (A), the polyfunctional aliphatic glycidyl ether compound (B) having a total chlorine amount of less than 0.7% by mass and optionally other thermosetting components, the curing agent (C), the organic solvent (D) and the additives (E) using a mixer, for example, a disperser, kneader, three roll mill or beads mill.

[Uses of Thermosetting resin composition]

For curing the thermoplastic resin composition according to the invention, other thermosetting resins, a curing catalyst or an antifoaming agent are mixed to it in accordance with necessity to prepare a solder resist ink or an ink for overcoating and the ink is applied by screen printing and thereafter dried and heated.

In spite of having excellent low temperature curing properties, tack properties and chemical resistance, the thermosetting resin composition of the invention can form a curing film having excellent pliability. The resulting cured film particularly has excellent pliability and electric insulating properties. Therefore, even when it is used to a thin wiring substrate such as FPC substrate, an insulating protective film having excellent electric properties and handling properties and also good pliability can be formed without occurrence of curl. The composition of the invention can be favorably used for an interlaminar insulating resin layer in a multilayer printed wiring board.

The insulating protective film can be formed by, for example, applying the thermosetting resin composition in a thickness of 10 to 100 μm on a substrate on which a circuit is formed and treated with heat at a temperature of 100 to 200°C for 10 to 60 min to be cured.

Although the thermosetting resin composition of the invention can have various uses, it is particularly suitable for insulating protective coating films of a printed wiring board or a flexible printed wiring board and interlaminar insulating resin layers of a multilayered printed wiring board which need to have thermosetting properties, adhesion with substrates, insulating properties, heat resistance, warp deformability and pliability.

The thermosetting resin composition of the invention can be used for an insulating protective coating film of chip on films (COF) and a sealing material for electronic parts such as IC, ultra LSI or the like.

EXAMPLE

The present invention will be described in more detail with reference to the following examples, but it should not be construed by the examples.

<Synthetic Example>

To a reactor equipped with a stirred, thermometer and condenser, 70. 7 g of "C-1065N" (polycarbonate diol, raw material diols (molar ratio) : 1,9-nonane diol / 2-methyl-1, 8-octane diol = 65/35, molecular weight: 991, manufactured by Kuraray Co., Ltd.) as a polyol compound, 13.5 g of 2,2-dimethylol butanoic acid (manufactured by Nippon Kasei Chemical Co., Ltd.) as a carboxyl group containing dihydroxy compound and 128.9 g of diethylene glycol ethylether acetate (manufactured by Daicel Chemical Industries Ltd.) as a solvent were fed and heated to 90°C to dissolve all the materials. The temperature of the reaction solution was lowered to 70°C and 42.4 g of methylene bis(4-cyclohexyl isocyanate) "Desmodur-W" (manufactured by Sumika Bayer Urethane Co., Ltd.) was added dropwise as a polyisocyanate to the solution over 30 min. After the dropping, the reaction was carried out at 80°C for 1 hr, at 90°C for 1 hr and at 100°C for 2 hr and it was confirmed the isocyanate was almost disappeared. Thereafter, 1.46 g of isobutanol (manufactured by Wako Pure Chemical Industries Ltd.) was added dropwise to the solution and the reaction was further carried out at 105°C for 1.5 hr. The resulting carboxyl group containing polyurethane had a number average molecular weight of 6,800 and the acid value of the solid components was 39.9 mg-KOH/g.

Example 1

To the polyurethane solution having a solid component concentration of 50 % by mass prepared in Synthetic Example, based on 100 % by mass of the polyurethane solid components, 6.5 % by mass of low chlorine polyfunctional aliphatic glycidylether ("EX321L" manufactured by Nagase Chemtex Corporation) as a thermosetting component, in which the epoxy group is 1.1 equivalent per carboxyl group of the polyurethane, and 0.6 % by mass of melamine as a curing agent were mixed. The resulting composition prepared by mixing these components was kneaded by passing through a three-roll mill (manufactured by Kodaira Seisakusho Co., Ltd., Type: RIII-1RM-2) three times, to prepare a solder resist ink.

Example 2

The procedure of Example 1 was repeated except for using a two functional aliphatic glycidylether ("EX212L" manufactured by Nagase Chemtex Corporation) as a thermosetting component in place of "EX321L" used in Example 1 to prepare a solder resist ink.

## Comparative Example 1

The procedure of Example 1 was repeated except for using a bisphenol A type epoxy ("EPICOTE1002" manufactured by Japan Epoxy Resin Co., Ltd.) as a thermosetting component in place of "EX321L" used in Example 1 to prepare a solder resist ink.

## Comparative Example 2

The procedure of Example 1 was repeated except for using an amine type epoxy ("YH-434" manufactured by Tohto Kasei Co., Ltd.) as a thermosetting component in place of "EX321L" used in Example 1 to prepare a solder resist ink.

## Comparative Example 3

The procedure of Example 1 was repeated except for using a cresol novolak type epoxy ("EOCN104S" manufactured by Nippon Kayaku Co., Ltd.) as a thermosetting component in place of "EX321L" used in Example 1 to prepare a solder resist ink.

## Comparative Example 4

The procedure of Example 1 was repeated except for using an alicyclic epoxy ("EHPE3150" manufactured by Daicel Chemical Industries Ltd.) as a thermosetting component in place of "EX321L" used in Example 1 to prepare a solder resist ink.

## Comparative Example 5

The procedure of Example 1 was repeated except for using a polyfunctional glycidyl ether ("EX411" manufactured by Nagase Chemtex Corporation) as a thermosetting component in place of "EX321L" used in Example 1 to prepare a solder resist ink.

## Comparative Example 6

The procedure of Example 1 was repeated except for using a heterocycle-containing epoxy ("HP7200" manufactured by Dainippon Ink and Chemicals Incorporated) as a thermosetting component in place of "EX321L" used in Example 1 to prepare a solder resist ink.

[Evaluation]

The solder resist inks prepared in Examples 1 and 2, and Comparative Examples 1 to 6 were evaluated on tack properties, which is an indication of curing properties, chemical resistance, electric properties, and warping properties, which is an indication of flexibility. The evaluation results are shown in Table 1.

<Total amount of chlorine>

A specimen is prepared in the following manner.

1) A specimen is weighed on a 300 mL Erlenmeyer flask with a ground-in stopper (until 0.1 mg unit).
2) To the flask, 30 mL of isopropanol and 20 mL of dioxane are added and dissolved therein.
3) About 1 g of metallic sodium is collected, cut into small pieces and added to the solution.
4) The mixture is refluxed in a hot bath at a temperature of 80 to 90°C for 30 min. When the metallic sodium is not dissolved, the heating is additionally carried out until the metallic sodium is completely dissolved.
5) After the complete dissolution of the metallic sodium, 10 ml of a 50% isopropanol aqueous solution is added from the upper part of a cooling tube.
6) The 300 mL Erlenmeyer flask with a ground-in stopper is taken off from a refluxing tube, and 40 mL of ion exchange water is added therein and the mixture is cooled with ice water.
7) Two or three droplets of 1% phenolphthalein are added using a pipette and thereby the mixture is neutralized with an acetic acid.
8) 20 mL of an acetic acid is moreover added and the mixture is cooled with ice water.
9) The content of the Erlenmeyer flask is moved to a 200 mL beaker. 20 mL of an acetic acid is collected using a special meter glass and the 300 mL Erlenmeyer flask with a ground-in stopper is washed with the acetic acid. The washings is also moved in the beaker.

The measurement is carried out using silver nitrate by means of an automatic titration apparatus.

The measurement value can be determined in the following formula.

```
The total amount of chlorine (%) = (A-B) x N x F x 35.49/10/W
```

A: The titrated amount of silver nitrate used in the titration,
F: The factor of silver nitrate used in the titration,
W: The weight (g) of a specimen,
N: The normality of a solution of silver nitrate used in the titration, and
B: Blank

<Curing properties (tackiness)>

A solder resist ink was applied on a #100 mesh polyester substrate with screen printing and cured with heat at 120°C for 30 min. A polyimide film having a thickness of 25 $\mu$m [Kapton (registered trademark) 100EN manufactured by DuPont-Tray Co., Ltd.] was used as the substrate. The coating films prepared by applying the solder resist ink and curing with heat, were laminated in such a way that the resist surfaces were faced each other and the tackiness was evaluated in the following criteria.
A: No tackiness
B: Slight tackiness
C: Tackiness with adhesion

<Chemical resistance>

A solder resist ink was applied on a #100 mesh polyester substrate with screen printing and cured with heat at 120°C for 30 min. A polyimide film having a thickness of 25 $\mu$m [Kapton (registered trademark) 100EN manufactured by DuPont-Tray Co., Ltd.] was used as the substrate. The coating film prepared by applying the solder resist ink and curing with heat was lightly rubbed back and forth 20 times using a cotton swab wetted with acetone. After the rubbing, the condition of the coating film was evaluated in the following three ranks.
A: Remarkable change is not observed on the coating film.
B: Scratches are observed on the coating film.
C: The coating film is melted.

<Electric insulating properties>

On the IPC-C (comb-like pattern) of a commercial substrate (IPC standard), a solder resist ink was applied with screen printing by a #100 mesh polyester plate and dried at 80°C for 30 min and thereafter cured with heat at 150°C for 1 hr. While the substrate was placed in an atmosphere of 85°C and a relative humidity of 85%, a bias voltage of 100 V was applied on the substrate and it was allowed to stand for 2000 hr. The electric insulating properties were evaluated in the following criteria.
A: No migration and no lowering of the insulation resistance value were observed.
B: After the lapse of 1000 to 2000 hr, migration or lowering of the insulation resistance value was observed.
C: On or before the lapse of 1000 hr, migration or lowering of the insulation resistance value was observed.

<Flexibility (Warping properties)>

On a substrate, a solder resist ink was applied with screen printing by a #100 mesh polyester plate and cured with heat at 120°C for 30 min. A polyimide film having a thickness of 25 $\mu$m [Kapton (registered trademark) 100EN manufactured by DuPont-Tray Co., Ltd.] was used as the substrate. The coating film prepared by applying the solder resist ink and curing with heat was cut by a circle cutter to make a 50 mm$\varnothing$ circle. The circle film had a convexly or concavely warped central. After 1 hr, the circle film was set in such a state that the convex surface was downward. The maximum vale and minimum value of the warp height from the plane were measured to determine the average value. The mark indicates the direction of warp. When the circle film was set in such a state that the convex surface was downward, the case where the cured film was higher to the polyimide film was shown by "+", while the case where the cured film was lower to the polyimide was shown by "-".

Table 1-1

| | Thermosetting component | | | |
|---|---|---|---|---|
| | Kind | Functional group number | Total chlorine amount | Molecular weight |
| Ex 1 | Aliphatic epoxy | 3 | lower than 0.3 | 312 |
| Ex 2 | Aliphatic epoxy | 2 | lower than 0.3 | 270 |
| Comp. Ex 1 | Bisphenol A type epoxy | 2 | lower than 0.3 | 1850 |
| Comp. Ex 2 | Amine type epoxy | 4 | at least 1 | 480 |
| Comp. Ex 3 | Cresol novolak type epoxy | 4 | lower than 0.3 | 1700 |
| Comp. Ex 4 | Alicyclic epoxy | at least 10 | lower than 0.3 | 2200 |
| Comp. Ex 5 | Aliphatic epoxy | 4 | at least 10 | 920 |
| Comp. Ex 6 | Heterocycle containing epoxy | 3 | lower than 0.3 | 780 |

Table 1-2

| | Properties | | | |
|---|---|---|---|---|
| | Curing prop. | Chemical resistance | Electric prop. | Warping prop. |
| Ex 1 | A | A | A | -1 |
| Ex 2 | A | B | A | -3 |
| Comp. Ex 1 | C | C | A | at least 5 |
| Comp. Ex 2 | A | A | C | 3 |
| Comp. Ex 3 | C | C | A | at least 5 |
| Comp. Ex 4 | C | B | A | at least 5 |
| Comp. Ex 5 | A | A | C | -1 |
| Comp. Ex 6 | C | C | A | 3 |

**Claims**

1. A thermosetting resin composition comprising:

   (A) a thermosetting resin and
   (B) a polyfunctional aliphatic glycidyl ether compound having a total chlorine amount of less than 0.7 % by mass.

2. The thermosetting resin composition according to claim 1 wherein the polyfunctional aliphatic glycidyl ether compound has a number average molecular weight of not more than 1000.

3. The thermosetting resin composition according to claim 1 wherein the thermosetting resin (A) is a carboxyl group containing resin.

4. The thermosetting resin composition according to claim 3 wherein the carboxyl group containing resin is a carboxyl group containing polyurethane.

5. The thermosetting resin composition according to claim 4 wherein the carboxyl group containing polyurethane is obtainable by allowing (a) a polyisocyanate compound to react with (b) a polyol compound and (c) a carboxyl group containing dihydroxy compound provided that the compound (c) is excluded in the compound (b).

6. The thermosetting resin composition according to claim 5 wherein the carboxyl group-containing polyurethane is obtainable by allowing (d) a mono-hydroxy compound and/or (e) a mono-isocyanate compound to react with the compounds (a), (b) and (c).

7. A solder resist ink comprising the thermosetting resin composition as claimed in any one of claims 1 to 6.

8. A cured product obtainable by curing the thermosetting resin composition as claimed in any one of claims 1 to 6.

9. An insulating protective film obtainable from the cured product as claimed in claim 8.

10. A printed wiring board, which is covered partly or all over with the cured product as claimed in claim 8.

11. A flexible printed wiring board, which is covered partly or all over with the cured product as claimed in claim 8.

12. A chip on film (COF), which is covered partly or all over with the cured product as claimed in claim 8.

13. An electronic part comprising the cured product as claimed in claim 8.

<div style="text-align: center">**INTERNATIONAL SEARCH REPORT**</div>

| | International application No. |
|---|---|
| | PCT/JP2007/053323 |

**A.  CLASSIFICATION OF SUBJECT MATTER**
*C08L101/00*(2006.01)i, *C08L63/00*(2006.01)i, *C08L75/04*(2006.01)i, *C09D11/00*
(2006.01)i, *C09D163/00*(2006.01)i, *C09D175/04*(2006.01)i, *C09D201/00*
(2006.01)i, *H05K3/28*(2006.01)i
According to International Patent Classification (IPC) or to both national classification and IPC

**B.   FIELDS SEARCHED**

Minimum documentation searched (classification system followed by classification symbols)
C08L1/00-101/16, C08G59/00-59/72, C09D1/00-201/10, H05K3/28,
G03F7/00-7/115

Documentation searched other than minimum documentation to the extent that such documents are included in the fields searched
    Jitsuyo Shinan Koho      1922-1996   Jitsuyo Shinan Toroku Koho   1996-2007
    Kokai Jitsuyo Shinan Koho   1971-2007   Toroku Jitsuyo Shinan Koho   1994-2007

Electronic data base consulted during the international search (name of data base and, where practicable, search terms used)

**C.   DOCUMENTS CONSIDERED TO BE RELEVANT**

| Category* | Citation of document, with indication, where appropriate, of the relevant passages | Relevant to claim No. |
|---|---|---|
| Y | JP 2005-173577 A  (Showa Denko Kabushiki Kaisha), 30 June, 2005 (30.06.05), Claims; Par. Nos. [0001], [0010], [0029], [0032], [0039], [0043] to [0053], [0089] (Family: none) | 1-13 |
| Y | JP 2005-120141 A  (Taiyo Ink Manufacturing Co., Ltd.), 12 May, 2005 (12.05.05), Claims; Par. No. [0014] (Family: none) | 1-13 |
| Y | JP 2005-105148 A  (Nagase Chemtex Corp.), 21 April, 2005 (21.04.05), Claims; Par. No. [0036]; examples 4, 6, 7 (Family: none) | 1-13 |

☐   Further documents are listed in the continuation of Box C.    ☐   See patent family annex.

| | |
|---|---|
| *    Special categories of cited documents:<br>"A"  document defining the general state of the art which is not considered   to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>   15 March, 2007 (15.03.07) | Date of mailing of the international search report<br>   27 March, 2007 (27.03.07) |
|---|---|
| Name and mailing address of the ISA/<br>   Japanese Patent Office | Authorized officer |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003292578 A
- JP H111999246759 A
- JP 2001342240 A
- JP 2003073453 A
- JP 2005320477 A

**Non-patent literature cited in the description**

- **P.J.FLORY.** Principles of Polymer Chemistry. Cornell Univ. Press, 1953